(19) Europäisches Patentamt / European Patent Office / Office européen des brevets

(11) **EP 4 368 854 A1**

(12) **EUROPEAN PATENT APPLICATION**
published in accordance with Art. 153(4) EPC

(43) Date of publication:
**15.05.2024 Bulletin 2024/20**

(21) Application number: **22836950.0**

(22) Date of filing: **06.07.2022**

(51) International Patent Classification (IPC):
*F16F 15/08* (2006.01)     *F16B 5/02* (2006.01)
*H05K 7/14* (2006.01)

(86) International application number:
**PCT/CN2022/104120**

(87) International publication number:
**WO 2023/280204 (12.01.2023 Gazette 2023/02)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.07.2021 CN 202110778824**

(71) Applicant: **Shanghai Yuxing Electronics
Technology Co., Ltd
Shanghai 201702 (CN)**

(72) Inventor: **FU, Bingkai
Shanghai 201702 (CN)**

(74) Representative: **Franke, Dirk
Franke & Partner
Patent- und Rechtsanwälte
Widenmayerstraße 25
80538 München (DE)**

(54) **CIRCUIT BOARD DAMPING MECHANISM AND VEHICLE-MOUNTED APPARATUS USING SAME**

(57)     The present application discloses a circuit board damping mechanism and a vehicle-mounted apparatus using same. The mechanism is used for fixing a circuit board having through hole(s) to a base plate, and the damping mechanism includes: an assembly plate fixedly arranged on the base plate; each fixing bolt including a nut and a stud, wherein the stud passes through the through hole(s) and cooperate with the nut to fix the circuit board to the assembly plate; and a damping gasket arranged between the circuit board and the nut of the fixing bolt. In the present application, a bearing ring portion of a damping rubber ring bears most weight of the circuit board; and when the apparatus shakes longitudinally, the bearing ring portion and the upper damping gasket form a vertical buffer structure; moreover, the elasticity of the rubber ring itself is utilized to tightly press against the circuit board under the action of the fixing bolt(s), thereby buffering a longitudinal impact on the circuit board while preventing the circuit board from shaking longitudinally.

Fig.3

# Description

## CROSS-REFERENCE TO RELATED APPLICATION

The present application claims the priority of Chinese invention application No. 202110778824.1, filed on July 09, 2021, entitled "CIRCUIT BOARD DAMPING MECHANISM AND VEHICLE-MOUNTED APPARATUS USING SAME".

## TECHNICAL FIELD

The present invention belongs to the technical field of mounting a circuit board with a casing of a vehicle-mounted apparatus, and in particular to a circuit board damping mechanism and a vehicle-mounted apparatus using same.

## BACKGROUND

In the vehicle-mounted apparatus or other apparatuses with motion characteristics or vibration characteristics, due to the vibration characteristics of an apparatus body itself, damping of the circuit board in the apparatus is always a big problem. For a damping mechanism in prior art, a circuit board is mostly mounted on a casing by using gaskets and bolts, and for individual apparatuses, the circuit board is bonded to the casing via glue. In the above-mentioned circuit board mounting process, vibration of the casing is directly transmitted to a circuit board inside via the bolt or glue connection between the casing and the circuit board, and the circuit board is easily damaged by a great impact on the casing.

## SUMMARY

In order to solve the above-mentioned connection problem between a casing of the circuit board and the circuit board, the present application provides a circuit board damping mechanism and a vehicle-mounted apparatus using same.

Specifically, the present application provides a damping mechanism, which is used for fixing a circuit board having one or more through holes to a base plate, wherein the damping mechanism includes:

one or more fixing bolts, each including a nut and a stud, wherein the stud passes through a through hole and cooperates with a nut to fix the circuit board to the base plate;
a damping rubber ring (gasket) sleeved outside the stud, wherein the damping rubber ring has a step shape and includes an upper damping ring portion and a lower bearing ring portion, the damping ring portion passes into the through hole to constitute a buffer structure of between the stud and an inner end surface of the through hole, and the bearing ring portion is clamped/positioned between the circuit board and the base plate to constitute a bearing structure of the circuit board; and
a damping gasket provided between the circuit board and the nut of the fixing bolt.

Further, the damping mechanism includes:

an assembly plate fixedly provided on the base plate;
a fixing bolt including a nut and a stud, wherein the stud passes through a through hole on the assembly plate and cooperate with the nut to fix the circuit board to the assembly plate;
the bearing ring portion is clamped between the circuit board and the assembly plate to constitute the bearing structure of the circuit board.

Further, the thickness of the damping ring portion in an axial direction of the stud is greater than the thickness of the circuit board that is mounted.

Further, the damping gasket includes an upper rubber pad and a lower rubber pad, wherein the upper rubber pad being positioned under the nut, the lower rubber pad being positioned between the upper rubber pad and the circuit board, the lower rubber pad being a soft pad, the hardness of the upper rubber pad being greater than the hardness of the lower rubber pad.

Further, a plurality of fixing holes are formed in the assembly plate, wherein at least two fixing holes cooperate with each other to form a fixing group which is cooperatively connected to the base plate, one screw is provided in each of the fixing holes of the fixing group, and the assembly plate is fixed to the base plate via the screws.

Further, the damping mechanism includes a self-clinching nut, wherein the assembly plate is provided with a mounting hole, and the fixing bolt further includes a threaded head passing through the mounting hole and cooperates with the self-clinching nut to fix the circuit board to the assembly plate.

The diameter of the threaded head is smaller than the diameter of the mounting hole and the diameter of the stud is larger than the diameter of the mounting hole.

Further, the length of the stud is slightly smaller than the sum of the thickness of the damping gasket and the thickness of the damping rubber ring in a natural state and larger than the sum of the thickness of the damping gasket and the thickness of the damping rubber ring in an extreme compression condition.

Further, the length H of the stud is:

$$H = \left( h' - \frac{h_3 \cdot \mu_3 \cdot k_3}{k' \cdot S_{n3}} \right) + (h_3 - h_3 \cdot \mu_3) + h_4$$

, wherein $h'$ represents the total thickness of the damping gasket, $h_3$ represents the thickness of the bearing ring portion in the damping rubber ring, $h_4$ represents the thickness of

the circuit board, $\mu_3$ represents a preset compression ratio of the bearing ring portion, $k'$ represents an elastic coefficient per unit cross-sectional area of the damping gasket, $k_3$ represents an elastic coefficient per unit cross-sectional area of the bearing ring portion in the damping rubber ring, and $S_{n3}$ represents a ratio of the cross-sectional areas of the damping gasket and the cross-sectional areas of the bearing ring portion.

Further, a gap between the damping rubber ring and the stud is less than 1 mm, and the thickness of the damping ring portion is greater than the thickness of the mounted circuit board by at least 1 mm.

Further, the inner diameter of the damping gasket is smaller than the inner diameter of the damping rubber ring.

Further, the base plate is an upper base plate or a lower base plate of a casing of a vehicle-mounted apparatus.

The present application also provides a vehicle-mounted apparatus using the circuit board damping mechanism of any one of the above.

The base plate in the present application refers to a basic plate of the area to which the circuit board is applied or mounted, e.g. it may be the outer casing of a vehicle-mounted apparatus or the casing, side walls, etc. of other apparatuses with motion or vibration characteristics.

The advantages of the present application are: (1) by using the assembly plate as a buffer plate between the base plate and the circuit board, during the mounting process, the circuit board does not contact with the base plate (which also serves as the main machine casing), and the vibration of the casing will not be directly transmitted to the circuit board; at the same time, a double-layer structure of the casing and the assembly plate enhances the mechanical strength of the casing; in addition, the assembly plate plays a role of switching between the base plate and the circuit board, and thus there is no requirement for the size and specification of the circuit board, thus reducing the cost of customizing the circuit board; (2) the damping rubber ring is made of a flexible material and has a shape of a step structure; the lower bearing ring portion is clamped between the circuit board and the assembly plate; the bearing ring portion is in surface contact with both the circuit board and the assembly plate under compression; the force of pressure there between is uniform and the friction force of the soft rubber surface is large to avoid vibration of the circuit board in an axial direction and a radial direction; at the same time, the bearing ring portion is relatively soft and with small stress at the contact surface which can extend the service life of the circuit board under severe working conditions; the damping ring portion extends into the through hole to provide buffering between the stud and the circuit board; (3) the damping gasket cooperates with the bearing ring portion and the nut to clamp the circuit board, and the damping gasket, the circuit board and the bearing ring portion are respectively in surface contact to damp the vibration of the circuit board in the radial direction of the stud.

## BRIEF DESCRIPTION OF THE DRAWINGS

In order to explain the embodiments of the present invention or the technical solutions in the prior art more clearly, a brief description will be given below with reference to the accompanying drawings which are used in the description of the embodiments or the prior art, and it is obvious that the drawings in the description below are merely some embodiments of the present invention, and it would be obvious for a person skilled in the art to obtain other drawings according to these drawings without involving any inventive effort.

FIG. 1 is a schematic side view according to an embodiment of the present application;
FIG. 2 is an exploded schematic diagram showing the structure of FIG. 1 according to an embodiment;
FIG. 3 is a structural schematic diagram of a fixing bolt and circuit board cooperating structure according to an embodiment of the present application;
FIG. 4 is a structural exploded schematic diagram of an apparatus according to an embodiment of the present application;
FIG. 5 is a structural schematic bottom view of an apparatus according to an embodiment of the present application;
FIG. 6 is a structural schematic top view of an apparatus according to an embodiment of the present application.
FIG. 7 is a structural schematic diagram of a fixing bolt according to an embodiment of the present application.

## DETAILED DESCRIPTION

In order that a person skilled in the art may understand the teachings of the present application in a better way, the present invention will now be described in further detail with reference to the accompanying drawings and examples.

The technical solutions of the present application will be described clearly and completely with reference to the drawings, and it should be apparent that the described embodiments are some, but not all, embodiments of the present application. Based on the embodiments in the present application, all other embodiments obtained by a person skilled in the art without involving any inventive effort are within the scope of protection of the present application.

In the description of the present application, it should be noted that the terms "center", "upper", "lower", "left", "right", "vertical", "horizontal", "inner", "outer" and the like indicating orientations or positional relationships based on the orientation or positional relationships shown in the figures, are merely for convenience in describing and simplifying the description, and do not indicate or imply that the referenced apparatuses or elements must have a particular orientation, be constructed and operated in a particular orientation, and thus should not be construed as limiting the present application. Further, the terms "first", "second", and "third" are used for descriptive purposes only and are not to be construed as indicating or implying relative importance.

In the description of the present application, it is to be appreciated that, unless expressly specified and limited otherwise, the terms "mounted", "coupled", and "connected" are to be interpreted broadly, for example, interpreted as being fixedly connected, removable connected, or integrally connected; it may be a mechanical connection or an electrical connection; it may be connected directly or indirectly through an intermediary and may be internal to the two elements. For a person skilled in the art, the specific meaning of the above terms in the present application may be appreciated according to specific situations

The present invention will now be described in further detail with reference to the accompanying drawings.

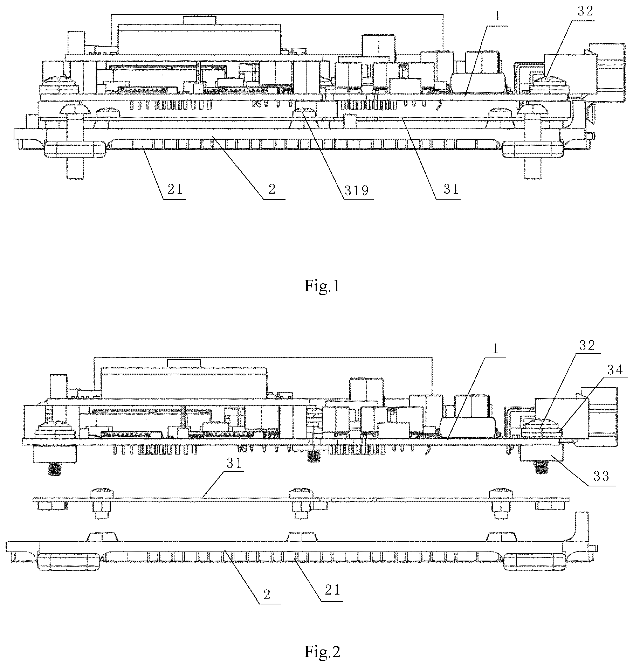

One embodiment of a circuit board damping mechanism of the present application is shown in FIGS. 1-4. The circuit board damping mechanism is used for fixing a circuit board 1 having through hole(s) to a base plate 2.

With reference to FIG. 2, the damping mechanism includes:

> an assembly plate 31, wherein the assembly plate 31 is fixedly arranged on the base plate 2;
> fixing bolt(s) 32, each including a nut 321 and a stud 322, the stud 322 fitting the nut 321 through the through hole to fix the circuit board 1 to the assembly plate 31;
> a damping rubber ring 33, wherein the damping rubber ring 33 has a step shape and includes an upper damping gasket portion 331 and a lower bearing ring portion 332, the damping ring portion 331 penetrates/passes into the through hole to constitute a buffer structure of the stud 322 and an inner end surface of the through hole, and the bearing ring portion 332 is clamped between the circuit board 1 and the assembly plate 31 to constitute a bearing structure of the circuit board 1;
> a damping gasket 34 provided between the circuit board 1 and the nut 321 of the fixing bolt 32.

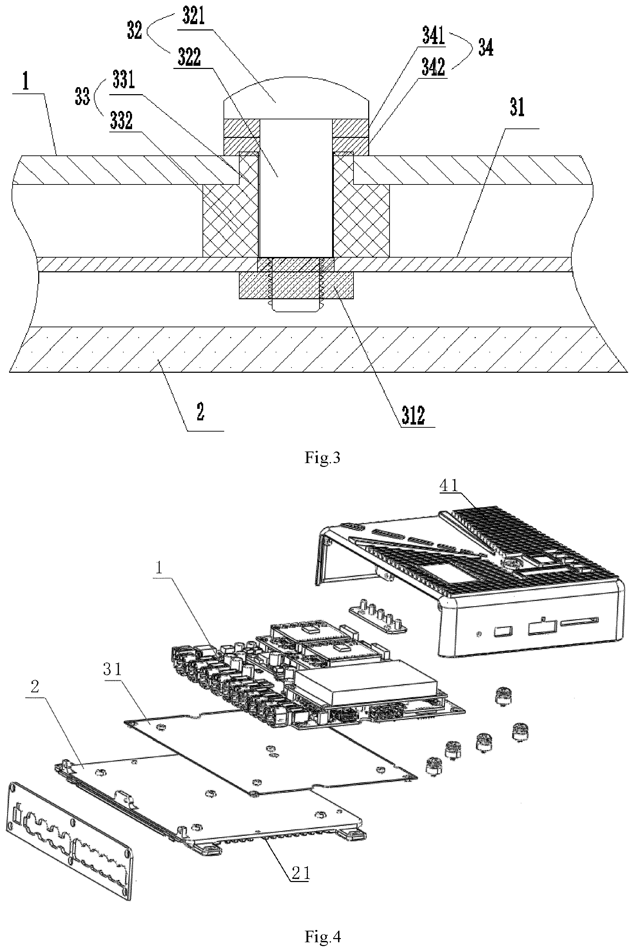

In this embodiment, in combination with FIG. 3, the bearing ring portion 332 of the damping rubber ring 33 bears most of the weight of the circuit board 1; and when the apparatus (on which the damping mechanism is mounted) shakes longitudinally, the bearing ring portion 332 and the upper damping gasket 34 use as a vertical buffer structure; moreover, the elasticity of the rubber ring itself is utilized to tightly press against the circuit board 1 under the action of the fixing bolt 32, thereby buffering a longitudinal impact on the circuit board 1 while preventing the circuit board 1 from shaking vertically.

The thickness of the damping ring portion 331 in an axial direction of the stud 322 is greater than the thickness of the mounted circuit board 1. In this embodiment, the damping ring portion 331 extends between the fixing bolt 32 and the through hole of the circuit board 1, and the damping ring portion 331 serves to buffer the lateral impact between the through hole of the circuit board 1 and the fixing bolt 32, and at the same time cooperates with the damping gasket 34 and the bearing ring portion 332 to constitute a positioning structure for the through hole of the circuit board, so that there is no direct contact between the circuit board 1 and the fixing bolt 32, and damage to the circuit board 1 caused by the rigid fixing bolt under the impact force is avoided.

In the embodiment shown in FIGS. 1 and 2, optionally, the assembly plate 31 may also be omitted and the circuit board 1 with through holes may be fixed directly to the base plate 2. That is, the base plate 2 is perforated or the fixing bolt 32 is directly fixed to the base plate 2 via a fixing hole between the assembly plate 31 and the base plate 2, and the base plate 2 is directly connected to the damping rubber ring 33 and the circuit board 1, therefore, the assembly plate 31 is omitted to reduce costs. However, this structure has a higher demand for the base plate 2, requiring that the base plate 2 must adapt with the circuit board 1, as compared with the structure that including an assembly plate, and thus it is less flexible than the structure that including an assembly plate 31. In the present invention, the assembly plate 31 also has a switching function, the assembly plate 31 has a simple plate shape, and the base plate 2 is generally an apparatus casing. It is simple and quick to mount the circuit board 1 by punching holes at various positions on the assembly plate 31, as compared with punching holes on the casing, and the cost is lower. Furthermore, the circuit boards 1 with different sizes and specifications may be mounted by punching holes at different positions on the assembly plate 31 that has the same specification, and then the assembly plate 31 are fixed to the base plate 2 with the same specification, thereby reducing the mounting cost of the circuit board 1 and the base plate 2.

Referring to FIG. 3, in this embodiment, the damping gasket 34 includes an upper rubber pad 341 and a lower rubber pad 342, the upper rubber pad 341 is provided on a lower side of the nut 321, the lower rubber pad 342 is provided between the upper rubber pad 341 and the circuit board 1, the lower rubber pad 342 is a soft pad, and the hardness of the upper rubber pad 341 is greater than that of the lower rubber pad 342. By using an up-down cooperating structure of the damping gasket 34 of this embodiment, the upper hard rubber pad 341 can avoid adhesion with the nut 321, ensuring that the nut 321 may be fully rotated to press the circuit board 1, and the lower soft lower rubber pad 342 mainly plays a buffering role, ensuring that the pressure transmitted by the nut 321 is evenly distributed on the circuit board 1, and avoiding uneven stress on the circuit board 1. In the double-layer structure of the upper rubber pad 341 and the lower rubber pad 342 in the present application, the lower rubber pad 342 has a good elasticity, and respectively provides an elastic force for the nut 321 and the circuit board 1, and after the nut 321 is tightened, the elastic force is evenly distributed to the nut 321 via the upper rubber pad 341, which may also play a self-tightening function on the nut 321, avoiding the loosening of the fixing bolt over time during use.

With reference to FIGS. 1 and 2, the assembly plate 31 is provided with a plurality of fixing holes, wherein at least two fixing holes cooperate with each other to form a fixing group which is cooperatively connected to the base plate 2, screws 319 are provided in the fixing holes of the fixing group, and the assembly plate 31 is fixed to the base plate 2 via the screws 319. In the present application, the assembly plate 31 is fixed in a manner of "point fixing" between the fixing hole group and the bottom plate 2, and the circuit board 1 is fixed the assembly plate 31 via the fixing bolt 32 in a manner of "point fixing"; a fixing method of "point fixing" may reduce the fixed area and vibration transmission area; and by using the assembly plate 31 arranged in the middle, a damping effect may be fully exerted, and the impact of the bottom plate 2 on the circuit board 1 may be damped to the maximum extent. The assembly plate 31 is made of a material having a certain elasticity, but with relatively poor elasticity, so as to avoid vibration of the circuit board 1 caused by too good elasticity while providing damp of the vibration.

With reference to FIG. 3, a self-clinching nut (riveting nut) 312 is provided on a side of the assembly plate 31 close to the bottom plate 2, and the stud 322 cooperates with the self-clinching nut 312 to fix the circuit board 1 to the assembly plate 31. In the present technical solution, the self-clinching nut 312 cooperates with the stud 322 to avoid directly screw-joint the stud 322 with the assembly plate 31, thereby extending the service life of the assembly plate 31. During subsequent maintenance, the self-clinching nut 312 or the stud 322 rather than the assembly plate 31 may be simply replaced. At the same time, a standard hole rather than a screw hole is provided on the assembly plate 31 to facilitate the selection of the existing self-clinching nut 312 and the fixing bolt 32 to facilitate the mass production of the mechanism of the present application.

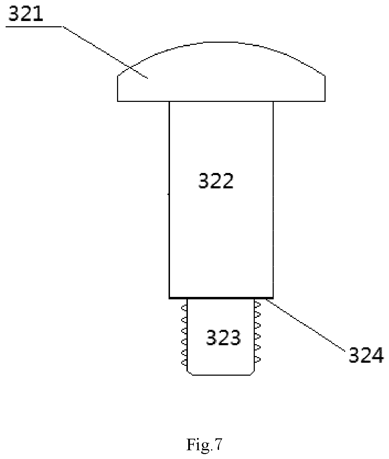

In this embodiment, a self-clinching nut 312 of a novel structure is used. As shown in FIGS. 3 and 7, the assembly plate 31 is provided with a mounting hole, and a threaded head 323 is provided at the lower end of the stud 322. The diameter of the threaded head 323 is smaller than the diameter of the mounting hole of the assembly plate 31, the diameter of the threaded stud 322 is greater than the diameter of the mounting hole of the assembly plate 31, and the threaded head 323 is matched with the self-clinching nut 312 to lock the self-clinching nut 312 via a nut 321. A shoulder area 324 is formed between the stud 322 and the threaded head 323 for abutment against the assembly plate 31 to avoid over-compression of the damping gasket 34 and the damping rubber ring 33 during locking of the self-clinching nut 312 which would make the damping gasket 34 and the damping rubber ring 33 lose elasticity.

The length of the stud 322 is set so that it is slightly less than the sum of the thickness of the damping gasket 34 and of the damping rubber ring 33 in a natural state, and significantly greater than the sum of the thickness of the damping gasket 34 and of the damping rubber ring 33 in an extreme compression condition. Its length may be set on the basis of a preset compression ratio for the damping rubber ring 33, so that initially, there is both a certain compression therefor and a sufficient elastic space is reserved. For example, the length thereof is set to be equal to the sum of the thicknesses of the damping gasket 34 and the damping rubber ring 33 under an overall compression ratio of 10-20%.

Preferably, the length H of the stud 322 is set

$$H = h_1 + (h_2 - \frac{h_3 \cdot \mu_3 \cdot k_3}{k_2 \cdot S_{23}}) + (h_3 - h_3 \cdot \mu_3) + h_4$$

to:

wherein $h_1$ represents the thickness of the upper rubber pad 341; since the upper rubber pad 341 is made of a hard material and is substantially not compressed, the original thickness thereof is used here; $h_2$ represents the thickness of the lower rubber pad 342; $h_3$ represents the thickness of the bearing ring portion 332 in the damping rubber ring 33; $h_4$ represents the thickness of the circuit board 1, $\mu_3$ represents a preset compression ratio of the bearing ring portion 332; $k_2$ represents an elastic coefficient per unit cross-sectional area of the lower rubber pad 342; $k_3$ represents an elastic coefficient per unit cross-sectional area of the bearing ring portion 332 of the damping rubber ring 33; $S_{23}$ represents a ratio of the cross-sectional area of the lower rubber pad 342 to the bearing ring portion 332, i.e., the ratio is equal to the cross-sectional area of the lower rubber pad 342 divided by the cross-sectional area of the bearing ring portion 332. In this manner, an optimal compression amount of the damping rubber ring 33 and the upper and lower rubber pads 341 and 342 may be ensured to provide better damping performance.

If the difference in elasticity of the two gaskets in the damping gasket 34 is not taken into account, but taken as a whole, the length H of the stud 322 is:

$$H = (h' - \frac{h_3 \cdot \mu_3 \cdot k_3}{k' \cdot S_{n3}}) + (h_3 - h_3 \cdot \mu_3) + h_4$$

, wherein $h'$ represents the total thickness of the damping gasket 34, $h_3$ represents the thickness of the bearing ring portion 332 in the damping rubber ring 33, $h_4$ represents the

thickness of the circuit board 1, $\mu^3$ represents a preset compression ratio of the bearing ring portion 332, $k'$ represents an elastic coefficient of per cross-sectional area of the damping gasket 34 as a whole, $k_3$ represents the elastic coefficient per unit cross-sectional area of the bearing ring portion 332 in the damping rubber ring 33, and $S_{n3}$ represents a ratio of the cross-sectional areas of the damping gasket 34 and the bearing ring portion 332. That is, $S_{n3}$ is equal to a quotient of dividing the cross-sectional areas of the bearing ring portion 332 by the cross-sectional areas of the damping gasket 34. The "cross-sectional area of the bearing ring portion 332" refers to the cross-sectional area of the bearing ring portion 332 in contact with the assembly plate 31.

Referring to FIG. 3, in this embodiment, a gap between the damping rubber ring 33 and the stud 322 is less than 1 mm. The damping rubber ring 33 of this embodiment does not closely contact with the stud 322, but leaves a gap of less than 1 mm to facilitate the stud 322 to penetrate through and the damping rubber ring 33 to sleeve thereon, and improve the mounting speed.

Referring to FIG. 3, in this embodiment, the thickness of the damping ring portion 331 is greater than the thickness of the mounted circuit board 1 by at least 1mm. In this embodiment, the thickness of the damping ring portion 331 is greater than the thickness of the circuit board 1, and the nut 321 presses the damping ring portion 331 to the inner wall of the circuit board 1 and the outside of the bolt 32 via the damping gasket 34 during mounting, so that the damping ring portion 331 is further compressed/pressed between the circuit board 1 and the stud 322, avoiding the circuit board 1 from shaking transversely, and enhancing fixation of the circuit board 1.

Referring to FIG. 3, in one embodiment of the present application, the inner diameter of the damping gasket 34 is smaller than the inner diameter of the damping rubber ring 33. In this technical solution, the damping gasket 34 sufficiently shields the damping rubber ring 33 to improve the tightness of the nut 321 to be fixed, and prevents the damping ring portion 331 from pressing against the inner diameter of the damping gasket 34, thereby improving the product life. At the same time, this embodiment may also be fitted to a structure in which the thickness of the damping ring portion 331 is greater than the thickness of the mounted circuit board 1 by at least 1 mm, and the gap between the damping rubber ring 33 and the stud 322 is less than 1 mm to ensure that, under the shielding and compression of the damping gasket 34, the damping rubber ring 33 may actively fill the gap between the circuit board 1 and the stud 322 after the nut 321 is tightened to generate a squeezed self-tightening force between the circuit board 1 and the stud 322, improving the security of the product, and avoiding the circuit board 1 from shaking transversely.

The base plate 2 is an upper base plate or a lower base plate of a casing of a vehicle-mounted apparatus. In this embodiment, the base plate 2 of the present application may be an upper base plate of an apparatus casing implemented by mounting a circuit board in a hanging manner, or a lower base plate implemented by mounting the circuit board 1 in a supporting manner. The upper and lower base plates of the present application are not simply upper and lower direction referring to the direction of gravity, but are determined with reference to the direction of the apparatus.

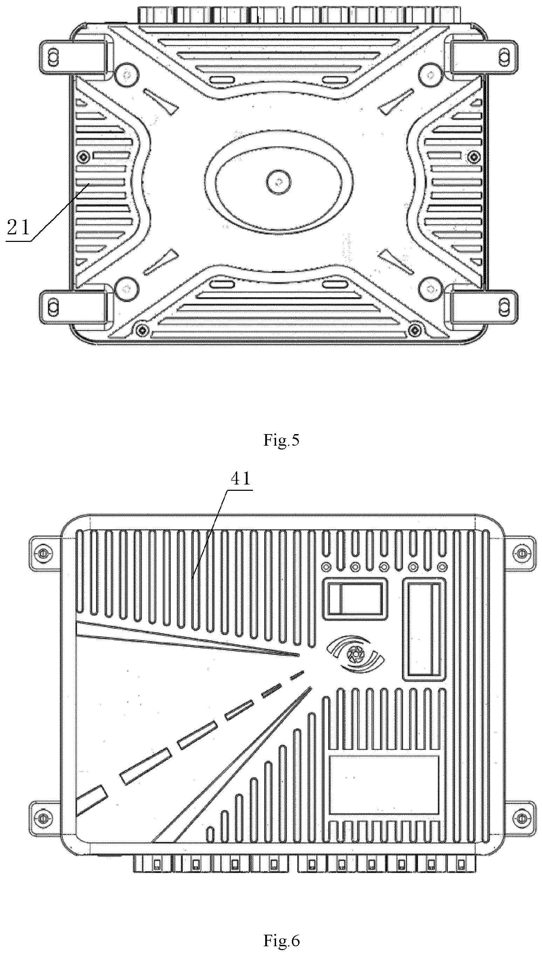

The application also provides a vehicle-mounted electronic apparatus uses the damping mechanism according to any one of the embodiments described above. With reference to FIGS. 4 to 6, the present application provides a vehicle-mounted apparatus. In this apparatus, in addition to the damping mechanism of the present application, in order to facilitate heat dissipation of the circuit board 1, an upper heat dissipation area 41 is provided on an upper bottom plate of the apparatus, and a lower heat dissipation area 21 is provided on a lower bottom plate of the apparatus; with reference to FIGS. 5 and 6, both the upper heat dissipation area 41 and lower heat dissipation area 21 use protrusions arranged in parallel and heat dissipation flow channels between the protrusions. The convection of air in the heat dissipation flow channels is improved, while the upper and lower heat dissipation areas of the apparatus are increased, through the cooperation of the protrusions and the flow channels, thereby further optimizing the heat dissipation of the present application.

While the principles of the present invention have been described in detail in connection with preferred embodiments thereof, it will be appreciated by a person skilled in the art that the above-described embodiments are merely illustrative of exemplary implementations of the present invention, and are not intended to limit the scope of the present invention. The details of the embodiments are not to be construed as limiting the scope of the present invention, and any obvious variations thereof, such as equivalent alterations, simple substitutions, and the like, may be made without departing from the spirit and scope of the present invention.

## Claims

1.  A circuit board damping mechanism, which is used for fixing a circuit board (1) having one or more through holes to a base plate (2), wherein the damping mechanism includes:

    one or more fixing bolts (32), each including a nut (321) and a stud (322), wherein the stud (332) passes through a through hole and cooperates with a nut (321) to fix the circuit board (1) to the base plate (2);
    a damping rubber ring (33) sleeved outside the stud (322), wherein the damping rubber ring (33) has a step shape and includes an upper damping ring portion (331) and a lower bearing ring portion (332), the upper damping ring portion (331) passes into the through hole to constitute a buffer structure between the stud (322) and an inner end surface of the through hole, and the bearing ring portion (332) is clamped between the circuit board (1) and the base plate (2) to constitute a bearing structure of the circuit board (1); and
a damping gasket (34) provided between the circuit board (1) and the nut (321) of the fixing bolt (32).

2. The circuit board damping mechanism according to claim 1, further comprising an assembly plate (31) fixedly provided on the base plate (2);

wherein the stud (332) passes through the through hole and cooperates with the nut (321) to fix the circuit board (1) to the assembly plate (31);
the bearing ring portion (332) is clamped between the circuit board (1) and the assembly plate (31) to constitute the bearing structure of the circuit board (1).

3. The circuit board damping mechanism according to claim 1 or 2, wherein the thickness of the damping ring portion (331) in an axial direction of the stud (322) is greater than the thickness of the circuit board (1) that is mounted.

4. The circuit board damping mechanism according to claim 1, wherein the damping gasket (34) includes an upper rubber pad (341) and a lower rubber pad (342), the upper rubber pad (341) being positioned under the nut (321), the lower rubber pad (342) being positioned between the upper rubber pad (341) and the circuit board (1), the lower rubber pad (342) being a soft pad, and the hardness of the upper rubber pad (341) being greater than the hardness of the lower rubber pad (342).

5. The circuit board damping mechanism according to claim 2, wherein a plurality of fixing holes are formed in the assembly plate (31), wherein at least two fixing holes cooperate with each other to form a fixing group which is cooperatively connected to the base plate (2), one screw (319) is provided in each of the fixing holes of the fixing group, and the assembly plate (31) is fixed to the base plate (2) via the screw (319).

6. The circuit board damping mechanism according to claim 2, wherein the circuit board damping mechanism further includes a self-clinching nut (312), wherein the assembly plate (31) is provided with a mounting hole, and the fixing bolt (32) further includes a threaded head (323) passing through the mounting hole and cooperates with the self-clinching nut (312) to fix the circuit board (1) to the assembly plate (31).

7. The circuit board damping mechanism according to claim 6, wherein the diameter of the threaded head (323) is smaller than the diameter of the mounting hole and the diameter of the stud (322) is larger than the diameter of the mounting hole.

8. The circuit board damping mechanism according to claim 1, wherein the length of the stud (322) is slightly smaller than the sum of the thickness of the damping gasket (34) and the thickness of the damping rubber ring (33) in a natural state and larger than the sum of the thickness of the damping gasket (34) and the thickness of the damping rubber ring (33) in an extreme compression condition.

9. The circuit board damping mechanism according to claim 1, wherein the length H of the stud (322) is:

$$H=(h'-\frac{h_3 \cdot \mu_3 \cdot k_3}{k' \cdot S_{n3}})+(h_3-h_3 \cdot \mu_3)+h_4$$

wherein $h'$ represents the total thickness of the damping gasket (34), $h_3$ represents the thickness of the bearing ring portion (332) in the damping rubber ring (33), $h_4$ represents the thickness of the circuit board (1), $\mu_3$ represents a preset compression ratio of the bearing ring portion (332), $k'$ represents an elastic coefficient per unit cross-sectional area of the damping gasket (34), $k_3$ represents an elastic coefficient per unit cross-sectional area of the bearing ring portion (332) in the damping rubber ring (33), and $S_{n3}$ represents a ratio of the cross-sectional areas of the damping gasket (34) and the cross-sectional areas of the bearing ring portion (332).

10. The circuit board damping mechanism according to claim 1 or 2, wherein a gap between the damping rubber ring (33) and the stud (322) is less than 1 mm, and the thickness of the damping ring portion (331) is greater than the thickness of the circuit board (1) by at least 1 mm.

11. The circuit board damping mechanism according to claim 1 or 2, wherein the inner diameter of the damping gasket (34) is smaller than the inner diameter of the damping rubber ring (33).

12. The circuit board damping mechanism according to claim 1 or 2, wherein the base plate (2) is an upper base plate or a lower base plate of a casing of a vehicle-mounted apparatus.

13. A vehicle-mounted apparatus, wherein the vehicle-mounted apparatus includes the circuit board damping mechanism according to any one of claims 1 to 12.

Fig.1

Fig.2

Fig.3

Fig.4

21

Fig.5

41

Fig.6

321

322

323

324

Fig.7

## INTERNATIONAL SEARCH REPORT

| | International application No. |
| --- | --- |
| | **PCT/CN2022/104120** |

**A.   CLASSIFICATION OF SUBJECT MATTER**

   F16F 15/08(2006.01)i;   F16B 5/02(2006.01)i;   H05K 7/14(2006.01)i

According to International Patent Classification (IPC) or to both national classification and IPC

**B.    FIELDS SEARCHED**

Minimum documentation searched (classification system followed by classification symbols)

   F16F; F16B; H05K

Documentation searched other than minimum documentation to the extent that such documents are included in the fields searched

Electronic data base consulted during the international search (name of data base and, where practicable, search terms used)

   CNTXT, ENTXTC: 电路板, 孔, 隔, 吸, 减, 震, 振, 缓冲, 螺栓, 螺钉, 螺杆, 螺柱, 垫圈, 橡胶; ENTXT, VEN: print, board, circuit, pcb, hole, bore, orifice, vibrate, damp, bolt, screw, washer, rubber.

**C.    DOCUMENTS CONSIDERED TO BE RELEVANT**

| Category* | Citation of document, with indication, where appropriate, of the relevant passages | Relevant to claim No. |
| --- | --- | --- |
| PX | CN 113531039 A (SHANGHAI YUXING ELECTRONIC TECHNOLOGY CO., LTD.) 22 October 2021 (2021-10-22) <br> description, paragraphs 33-43, and figures 1-6 | 1-13 |
| X | JP 2019107959 A (ROBERT BOSCH GMBH) 04 July 2019 (2019-07-04) <br> description, paragraphs 4 and 12-63, and figures 1-4 | 1-13 |
| X | CN 103899513 A (BEIJING AEONMED CO., LTD.) 02 July 2014 (2014-07-02) <br> description, paragraphs 28-31, and figures 1-3 | 1-13 |
| A | CN 108397498 A (WENZHOU UNIVERSITY OUJIANG COLLEGE) 14 August 2018 (2018-08-14) <br> entire document | 1-13 |

☐ Further documents are listed in the continuation of Box C.     ☑ See patent family annex.

| | |
| --- | --- |
| *     Special categories of cited documents: <br> "A"   document defining the general state of the art which is not considered to be of particular relevance <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |

| Date of the actual completion of the international search | Date of mailing of the international search report |
| --- | --- |
| **07 September 2022** | **26 September 2022** |

| Name and mailing address of the ISA/CN | Authorized officer |
| --- | --- |
| **China National Intellectual Property Administration (ISA/ CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/104120**

| Patent document cited in search report | | | Publication date (day/month/year) | Patent family member(s) | | | Publication date (day/month/year) |
|---|---|---|---|---|---|---|---|
| CN | 113531039 | A | 22 October 2021 | CN | 215806004 | U | 11 February 2022 |
| JP | 2019107959 | A | 04 July 2019 | DE | 102018221730 | A1 | 19 June 2019 |
| CN | 103899513 | A | 02 July 2014 | None | | | |
| CN | 108397498 | A | 14 August 2018 | None | | | |

Form PCT/ISA/210 (patent family annex) (January 2015)

14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110778824